# FASCICULE DE BREVET EUROPEEN

(11) **EP 2 079 610 B1**
(45) Date de publication et mention de la délivrance du brevet: **17.02.2010**
(21) Numéro de dépôt: 07848286.6
(22) Date de dépôt: 25.09.2007
(51) Int. Cl.: B60R 16/023, B62D 5/04, H05K 5/06

(54) **CAPOT DE PROTECTION POUR SYSTEME INTEGRANT DE L'ELECTRONIQUE**
SCHUTZABDECKUNG FÜR EIN ELEKTRONIKINTEGRIERENDES SYSTEM
PROTECTIVE COVER FOR AN ELECTRONICS-INTEGRATING SYSTEM

(30) Priorité: 17.10.2006 FR 0609072
(43) Date de publication de la demande: 22.07.2009
(73) Titulaire: Jtekt Europe, 69540 Irigny (FR)
(72) Inventeur: GUILLARD, Grégory, 69700 Givors (FR)
(74) Mandataire: Maureau, Philippe
(86) Numéro de dépôt international: PCT/FR2007/001563
(87) Numéro de publication internationale: WO 2008/046976

(56) Documents cités:
- DE-A1- 10 348 358
- FR-A1- 2 854 604

## Description

La présente invention concerne un capot de protection, avec étanchéité améliorée, pour des systèmes intégrant de l'électronique, tels que les systèmes de direction assistée de véhicules automobiles, en particulier les systèmes de direction assistée électrique.

Dans une direction assistée électrique, il est prévu un calculateur et d'autres composants électroniques de pilotage de la direction, tels que des circuits de traitements de signaux issus de capteurs, qui sont placés dans des cavités, débouchant à l'extérieur, du carter de la direction ou d'autres parties de la direction. On peut ici se référer, d'une façon générale, à la demande de brevet français N° 2854604 A1 qui décrit un système de direction assistée électrique, avec son calculateur électronique ainsi que divers circuits et connexions électriques.

Une telle cavité, logeant des circuits et composants électroniques, est généralement obturée par un capot de protection, censé protéger les circuits et/ou composants électroniques vis-à-vis des éléments extérieurs, notamment de l'eau pouvant les atteindre et les détériorer ou en altérer le fonctionnement. A cet effet, le capot de protection comporte habituellement, sous sa face intérieure le long de sa périphérie, un joint d'étanchéité en forme de bourrelet qui, lors de la fixation de ce capot notamment au moyen de vis, s'applique contre le carter de la direction. Le capot étant métallique, le joint d'étanchéité périphérique est obtenu comme une partie surmoulée, en caoutchouc ou similaire.

D'une manière assez similaire, la demande de brevet allemand DE 10348358 A1, qui divulgue un capot du type défini dans le préambule de la revendication 1, décrit et illustre, plus particulièrement pour des systèmes électriques ou électroniques embarqués sur des véhicules automobiles, un boîtier qui délimite une cavité logeant des circuits électroniques et obturée par un capot de protection encliquetable, pourvu à sa périphérie d'un bourrelet d'étanchéité qui s'applique contre le bord du boîtier. Ledit capot comporte aussi, à l'extérieur du bourrelet, une paroi périphérique rigide qui, dans la position montée du capot, est située à l'extérieur du boîtier, sans possibilité de contact direct avec ce boîtier.

Bien que de telles dispositions soient théoriquement étanches, les exigences ou prescriptions des constructeurs automobiles définissant le niveau d'étanchéité requis pour les capots protégeant les systèmes électroniques sont telles qu'il reste difficile de les satisfaire avec les réalisations actuelles.

En particulier, ces exigences comprennent la tenue en immersion avec choc thermique, et l'étanchéité lors du lavage à haute pression et haute température. Le test de tenue en immersion consiste en la mise à température maximum de fonctionnement du système de direction, dans une enceinte climatique, et l'immersion dans une solution d'eau salée à une température de 0° C, ceci en faisant fonctionner le système de direction et en répétant le même cycle plusieurs fois. L'étanchéité lors du lavage à haute pression et haute température fait référence aux conditions de lavage par jet d'eau sous haute pression, dans des installations de lavage des véhicules. Il apparaît difficile, par un seul et même dispositif d'étanchéité, de satisfaire à cette double exigence.

La présente invention vise à pallier cette insuffisance, et elle a donc pour but de perfectionner les capots de protection pour systèmes intégrant de l'électronique, et notamment ceux des systèmes de direction assistée, de manière à améliorer sensiblement leur étanchéité, plus spécialement vis-à-vis d'un jet de liquide de lavage sous haute pression, et à satisfaire ainsi pleinement les exigences précédemment exposées.

A cet effet, l'invention a pour objet un capot de protection pour système intégrant le l'électronique, tel qu'un système de direction assistée de véhicule automobile, en particulier un système de direction assistée électrique, le capot de protection comportant, sous sa face intérieure le long de sa périphérie, un joint d'étanchéité notamment en forme de bourrelet prévu pour s'appliquer contre un carter, dans une partie du carter formant une cavité débouchant à l'extérieur et logeant des circuits et/ou composants électroniques, ce capot de protection étant essentiellement caractérisé par le fait qu'il comporte, à l'extérieur du joint d'étanchéité précité, une lèvre périphérique déformable à fonction brise-jet qui, dans la position montée du capot de protection, est dirigée vers le carter sans contact direct avec la surface de ce dernier.

Avantageusement, la lèvre périphérique à fonction brise-jet possède un profil incurvé, dont la concavité est dirigée vers la région centrale du capot de protection, de telle sorte que cette lèvre vienne au contact de la surface du carter sous l'effet de la pression d'un jet de liquide, notamment d'eau de lavage sous haute pression.

La lèvre périphérique à fonction brise-jet est réalisable comme une partie indépendante du joint d'étanchéité et fixée séparément au corps du capot de protection. En variante, la lèvre périphérique est conçue comme une partie rattachée au joint d'étanchéité et fixée avec celui-ci au corps du capot de protection. Dans tous les cas, cette lèvre périphérique à fonction brise-jet peut être obtenue et fixée par surmoulage du corps du capot de protection.

Ainsi, l'idée, inventive consiste à ajouter, à l'extérieur de la zone d'étanchéité principale entre le capot de protection et le carter, une lèvre brise-jet élastiquement déformable qui à l'état habituel n'est pas en contact avec le carter mais qui, grâce notamment à son profil incurvé, viendra temporairement en contact avec le carter sous l'effet de la pression élevée d'un jet d'eau de lavage. En d'autres termes, l'ajout de la lèvre brise-jet forme une "chicane" s'opposant à l'entrée d'eau, le fonctionnement étant tel que plus la pression du jet est élevée, plus la lèvre sera appuyée sur le carter et plus elle le rendra étanche. Ainsi, l'ensemble pourra satisfaire aux exigences ou prescriptions imposées, notamment celles d'étanchéité au lavage à haute pression et haute température grâce à la lèvre additionnelle brise-jet, tandis que le joint principal assure la fonction d'étanchéité en immersion.

De plus, la solution technique selon l'invention s'avère particulièrement simple et économique, puisqu'elle se limite au rajout d'une lèvre brise-jet qui peut être directement obtenue par surmoulage du capot de protection, de manière simultanée au joint principal d'étanchéité.

L'invention sera mieux comprise à l'aide de la description qui suit, en référence au dessin schématique annexé représentant, à titre d'exemple, une forme d'exécution de ce capot de protection pour système intégrant de l'électronique :
Figure 1 est une vue d'ensemble, en perspective, d'un système de direction assistée pourvu d'un capot de protection conforme à la présente invention ;
Figure 2 est une vue de côté, à plus grande échelle, de la partie de carter de ce système de direction recevant le capot de protection ;
Figure 3 est une vue de face de la cavité de cette partie de carter, obturée par ledit capot de protection ici retiré ;
Figure 4 est une vue en coupe longitudinale de cette cavité ;
Figure 5 est une vue en coupe transversale de ladite partie de carter avec sa cavité ;
Figure 6 est une vue en coupe longitudinale du capot de protection selon l'invention, prévu pour obturer la cavité des figures précédentes ;
Figure 7 représente, en coupe et à échelle agrandie, le détail des moyens d'étanchéité prévus à la périphérie du capot de protection de la figure 6 ;
Figure 8 est une vue similaire à la figure 7, illustrant à titre comparatif la zone périphérique d'un capot de protection selon l'état de la technique.

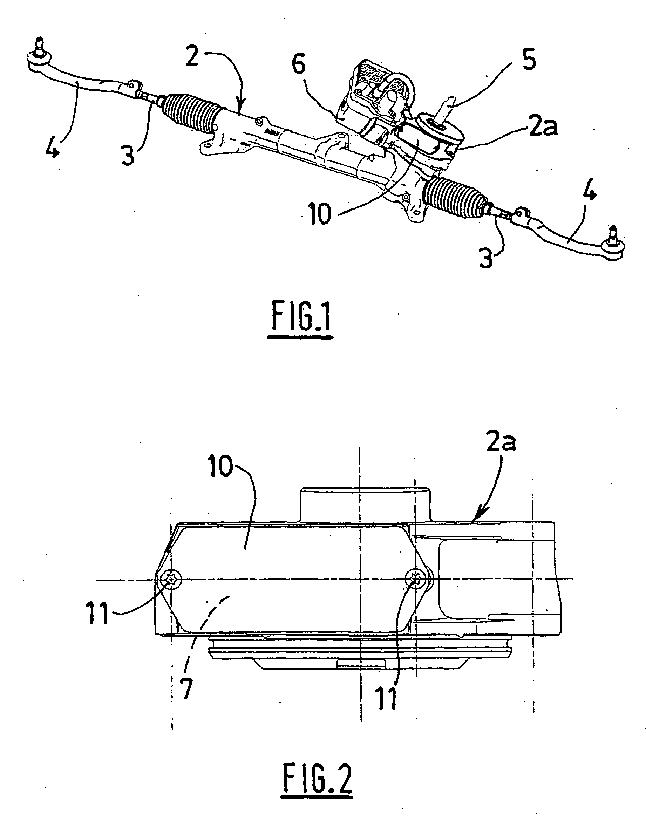

En se référant à la figure 1, on rappelle d'abord brièvement la structure d'un système de direction, auquel est notamment applicable la présente invention. Il s'agit, de façon habituelle, d'une direction à crémaillère qui possède un carter de direction allongé 2 dans lequel est montée coulissante la crémaillère (non visible), dont les extrémités sont accouplées à deux biellettes de direction 3, elles-mêmes raccordées à des boîtiers de rotule 4 côté roues, associés respectivement aux roues directrices droite et gauche du véhicule concerné. Une colonne de direction (ici non représentée) est raccordée à un arbre d'entrée 5 qui porte un pignon venant en prise avec la crémaillère. S'agissant ici d'une direction assistée électrique, celle-ci comporte encore un moteur électrique d'assistance 6 à deux sens de rotation, dont l'arbre de sortie est accouplé à l'arbre d'entrée 5 par l'intermédiaire d'un réducteur mécanique, par exemple à vis sans fin et roue tangente, de manière à transmettre un couple moteur additionnel (ou éventuellement un couple résistant) à cet arbre d'entrée 5. Le réducteur est logé dans une partie de carter 2a dans laquelle est aussi monté tournant l'arbre d'entrée 5.

La partie de carter 2a, mieux visible sur les figures 2 à 5, comporte latéralement une cavité 7 de forme générale parallélépipédique, débouchant à l'extérieur, laquelle loge des circuits et/ou composants électroniques de la direction assistée électrique, symbolisés sous la forme d'une plaquette de circuit 8. Il convient ici de rendre étanche la cavité 7 vis-à-vis des entrées d'eau ou d'impuretés en provenance de l'extérieur, et notamment vis-à-vis des jets de liquide de lavage sous haute pression.

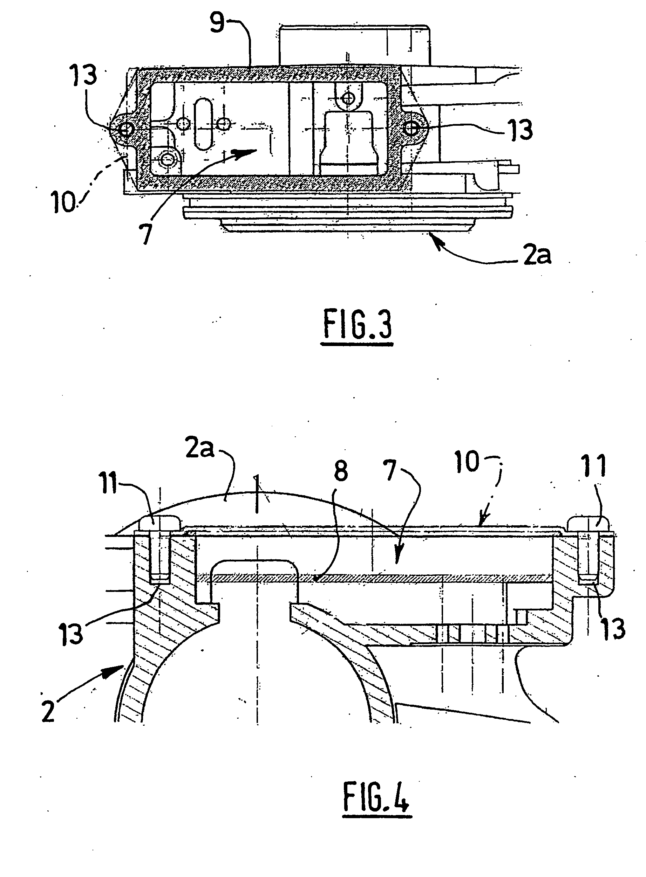

A cet effet, comme le montrent les figures 3 à 5, le bord rectangulaire de la cavité 7 présente une zone plane usinée 9 formant une portée de joint, prévue pour recevoir la zone périphérique d'un capot de protection 10, de forme rectangulaire ou oblongue correspondante. Le capot 10 est maintenu en place sur la partie du carter 2a au moyen de deux vis de fixation 11, notamment des vis auto-taraudeuses. Celles-ci traversent des trous correspondants 12 du capot de protection 10, et sont vissées respectivement dans deux trous opposés 13, creusés dans la zone de bordure 9 de la cavité 7.

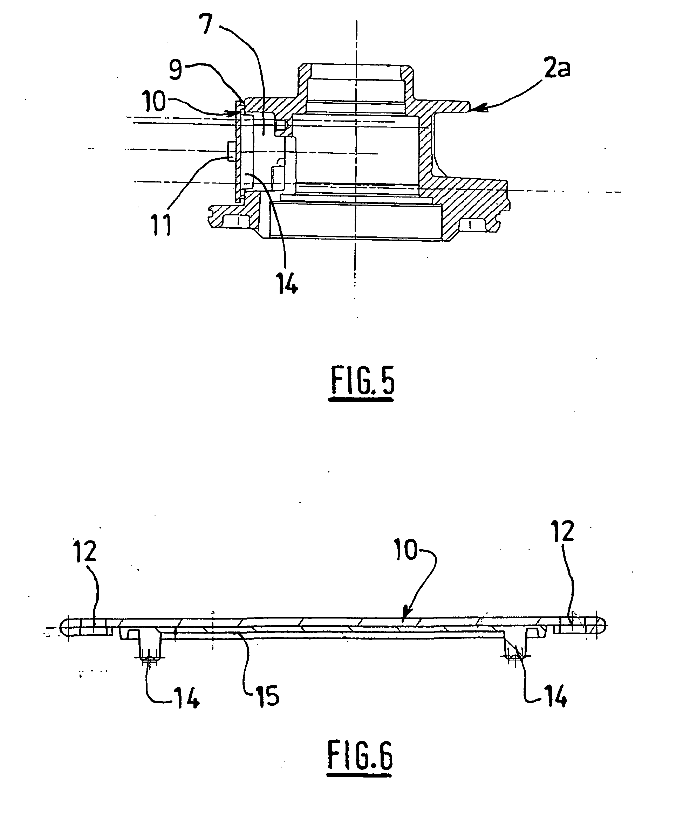

Comme le montre la figure 6, le capot de protection 10 possède un corps principal métallique, qui est ici pourvu de bossages 14 saillant sous sa face intérieure 15 et contribuant au maintien en place de la plaquette de circuit 8.

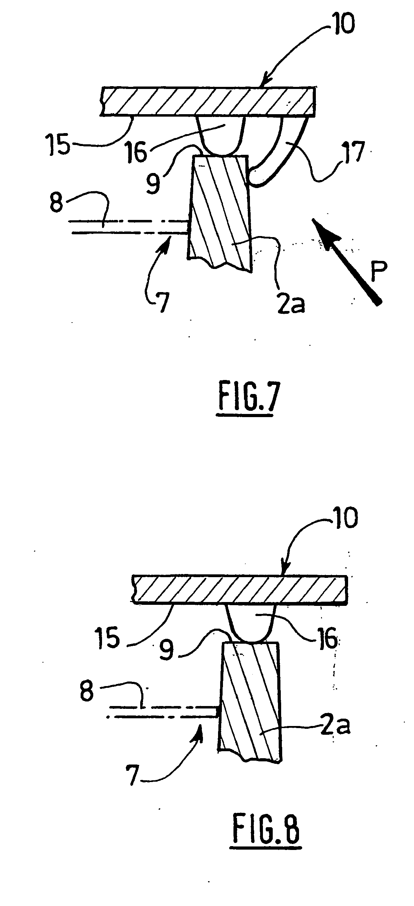

En se référant à la figure 7, le capot de protection 10 comporte à sa périphérie, sous sa face intérieure 15, un joint d'étanchéité principal 16 en forme de bourrelet. Lorsque le capot de protection 10 est fixé sur la partie de carter 2a au moyen des vis 11, le joint d'étanchéité 16 se trouve appliqué et comprimé contre la zone de bordure plane usinée 9 de la cavité 7, laquelle forme ainsi une portée de joint.

De plus, conformément à la présente invention, le capot de protection 10 comporte à l'extérieur du joint d'étanchéité principal 16, une lèvre périphérique brise-jet 17, faisant elle aussi saillie sous la face intérieure 15 du capot de protection 10. La lèvre brise-jet 17 possède un profil incurvé dont la concavité est dirigée vers la région centrale du capot de protection 10.

Comme le montre la figure 7, lorsque le capot de protection 10 est fixé contre la partie de carter 2a, la lèvre brise-jet 17 se situe face à cette partie de carter 2a, à l'extérieur de la zone de bordure 9 de la cavité 7. Dans les conditions normales, c'est-à-dire lorsque la lèvre brise-jet 17 n'est soumise à aucune sollicitation, celle-ci reste à une faible distance de la surface de la partie de carter 2a, comme le montre le dessin, l'étanchéité étant assurée par le joint principal 16. Par contre, sous l'effet de la forte pression hydraulique P d'un jet de liquide de lavage, comme suggéré ici par une flèche, la lèvre brise-jet 17 se déforme en fléchissant, et elle vient ainsi au contact de la surface de la partie de carter 2a, pour parfaire l'étanchéité de l'obturation de la cavité 7 par le capot de protection 10.

A titre comparatif, la figure 8 illustre la configuration de la zone périphérique de la cavité 7 et du capot de fermeture 10, dans l'état de la technique. Le capot de fermeture 10 étant dans ce cas dépourvu de toute lèvre brise-jet, seule existe l'étanchéité statique assurée par le joint 16, ce qui est insuffisant pour empêcher l'entrée d'eau d'un jet de lavage à haute pression et éventuellement à haute température.

Enfin, on notera que, comme pour le joint d'étanchéité 16 habituel, la lèvre brise-jet 17 est avantageusement réalisée en caoutchouc, et formée par surmoulage du capot de protection 10 ce qui assure directement sa fixation audit capot 10. Les surmoulages du joint d'étanchéité 16 et de la lèvre brise-jet 17 sont réalisables de façon simultanée, dans un processus de fabrication rationalisé.

Comme il résulte de la description précédente, l'invention est plus particulièrement applicable aux systèmes de direction assistée électrique, mais elle peut aussi s'appliquer à des systèmes de direction assistée hydraulique ou électro-hydraulique, dans la mesure où ils comportent également des circuits et/ou composants électroniques intégrés à leur carter. En particulier, le capot de protection de l'invention est utilisable pour l'obturation d'une cavité d'un carter de direction logeant, en tant que circuit électronique 8 à protéger, un circuit électronique de traitement du signal d'un capteur de couple d'un système de direction assistée de véhicule automobile.

L'on ne s'éloignerait pas du cadre de l'invention, telle que définie dans les revendications annexées :
- en modifiant les formes de détail du carter ou de la partie de carter concernée, et de sa cavité, ainsi que le contour du capot de protection ;
- en fixant le capot de protection sur le carter par un nombre quelconque de vis, auto-taraudeuses ou non, ou par tous autres moyens de fixation adaptés ;
- en réalisant la lèvre brise-jet en toute matière déformable appropriée ;
- en appliquant le même dispositif à des systèmes de direction de tous types, en des endroits variables du carter, ou encore en destinant ce dispositif à des systèmes autres que des directions de véhicules mais intégrant également de l'électronique, cette dernière pouvant prendre toute forme.

## Revendications

1. Capot de protection (10) pour système intégrant de l'électronique, tel qu'un système de direction assistée de véhicule automobile, en particulier un système de direction assistée électrique (2 à 6), le capot de protection (10) comportant, sous sa face intérieure (15) le long de sa périphérie, un joint d'étanchéité (16) notamment en forme de bourrelet prévu pour s'appliquer contre un carter (2), dans une partie (2a) du carter formant une cavité (7) débouchant à l'extérieur et logeant des circuits et/ou composants électroniques (8), **caractérisé en ce qu'**il comporte, à l'extérieur du joint d'étanchéité (16) précité, une lèvre périphérique déformable (17) à fonction brise-jet qui, dans la position montée du capot de protection (10), est dirigée vers le carter (2, 2a) sans contact direct avec ce dernier.

2. Capot de protection selon la revendication 1, **caractérisé en ce que** la lèvre périphérique (17) à fonction brise-jet possède un profil incurvé, dont la concavité est dirigée vers la région centrale du capot de protection (10) de telle sorte que cette lèvre (17) vienne au contact du carter (2, 2a) sous l'effet de la pression (P) d'un jet de liquide, notamment d'eau de lavage sous haute pression.

3. Capot de protection selon la revendication 1 ou 2, **caractérisé en ce que** la lèvre périphérique (17) à fonction brise-jet est réalisée comme une partie indépendante du joint d'étanchéité (16) et fixée séparément au corps du capot de protection (10).

4. Capot de protection selon la revendication 1 ou 2, **caractérisé en ce que** la lèvre périphérique (17) à fonction brise-jet est conçue comme une partie rattachée au joint d'étanchéité (16) et fixée avec celui-ci au corps du capot de protection (10).

5. Capot de protection, selon la revendication 3 ou 4, **caractérisé en ce que** la lèvre périphérique (17) à fonction brise-jet est obtenue et fixée par surmoulage du corps du capot de protection (10).

6. Capot de protection selon l'une des revendications 1 à 5, **caractérisé par** son utilisation pour l'obturation d'une cavité (7) d'un carter de direction (2, 2a) logeant, en tant que circuit électronique (8) à protéger, un circuit de traitement du signal d'un capteur de couple d'un système de direction assistée de véhicule automobile.

## Claims

1. Protective cover (10) for a system containing electronic means, such as a power-assisted motor vehicle steering system, especially an electrically power-assisted steering system (2 to 6), the protective cover (10) comprising, beneath its inside face (15), around its perimeter, a seal (16) in the form of, for example, a bead designed to be pressed against a housing (2), in a part (2a) of the housing that forms a cavity (7) which is open to the exterior and contains electronic circuits and/or components (8), which cover (10) is **characterized in that** it comprises, on the outside of the aforementioned seal (16), a deformable peripheral jet-breaker lip (17) which, when the protective cover (10) is in the assembled position, is oriented towards the housing (2, 2a) without direct contact with the latter.

2. Protective cover according to Claim 1, **characterized in that** the peripheral jet-breaker lip (17) has a curved profile, its concave side being towards the central region of the protective cover (10) in such a way that this lip (17) is pushed into contact with the housing (2, 2a) by the pressure (P) of a jet of liquid, such as high-pressure wash water.

3. Protective cover according to Claim 1 or 2, **characterized in that** the peripheral jet-breaker lip (17) is made as a part independent of the seal (16) and fixed separately to the body of the protective cover (10) .

4. Protective cover according to Claim 1 or 2, **characterized in that** the peripheral jet-breaker lip (17) is designed as a part attached to the seal (16) and fixed with this seal to the body of the protective cover (10).

5. Protective cover according to Claim 3 or 4, **characterized in that** the peripheral jet-breaker lip (17) is produced and fixed by overmoulding it onto the body of the protective cover (10).

6. Protective cover according to one of Claims 1 to 5, **characterized by** its use for closing a cavity (7) of a steering housing (2, 2a) containing, as an electronic circuit (8) requiring to be protected, a circuit for processing the signal from a torque sensor of a motor vehicle power-assisted steering system.

## Patentansprüche

1. Schutzabdeckung (10) für ein Elektronik umfassendes System, wie ein Servolenkungssystem eines Kraftfahrzeugs, insbesondere ein elektrisches Servolenkungssystem (2 bis 6), wobei die Schutzabdeckung (10) unter ihrer Innenseite (15) entlang ihres Umfangs eine Dichtung (16) insbesondere in Form eines Wulsts aufweist, der vorgesehen ist, um sich gegen ein Gehäuse (2) in einem Bereich (2a) des Gehäuses anzulegen, der einen Hohlraum (7) bildet, welcher nach außen mündet und Schaltungen und/oder Elektronikbauteile (8) aufnimmt, **dadurch gekennzeichnet, dass** sie außerhalb der erwähnten Dichtung (16) eine verformbare Umfangslippe (17) mit Strahlbrecherfunktion aufweist, die in der montierten Stellung der Schutzabdeckung (10) zum Gehäuse (2, 2a) ohne direkten Kontakt mit diesem gerichtet ist.

2. Schutzabdeckung nach Anspruch 1, **dadurch gekennzeichnet, dass** die Umfangslippe (17) mit Strahlbrecherfunktion ein gekrümmtes Profil besitzt, dessen Konkavität zum zentralen Bereich der Schutzabdeckung (10) gerichtet ist, so dass diese Lippe (17) unter der Wirkung des Drucks (P) eines Flüssigkeitsstrahls, insbesondere Waschwasser unter hohem Druck, mit dem Gehäuse (2, 2a) in Kontakt kommt.

3. Schutzabdeckung nach Anspruch 1 oder 2, **dadurch gekennzeichnet, dass** die Umfangslippe (17) mit Strahlbrecherfunktion als ein unabhängiger Teil der Dichtung (16) hergestellt und getrennt am Körper der Schutzabdeckung (10) befestigt ist.

4. Schutzabdeckung nach Anspruch 1 oder 2, **dadurch gekennzeichnet, dass** die Umfangslippe (17) mit Strahlbrecherfunktion als ein mit der Dichtung (16) verbundenes und mit dieser am Körper der Schutzabdeckung (10) befestigtes Teil konzipiert ist.

5. Schutzabdeckung nach Anspruch 3 oder 4, **dadurch gekennzeichnet, dass** die Umfangslippe (17) mit Strahlbrecherfunktion durch Überformen des Körpers der Schutzabdeckung (10) erhalten und befestigt wird.

6. Schutzabdeckung nach einem der Ansprüche 1 bis 5, **gekennzeichnet durch** ihre Verwendung zum Verschließen eines Hohlraums (7) eines Lenkungsgehäuses (2, 2a), in dem als zu schützender elektronischer Schaltkreis (8) eine Verarbeitungsschaltung des Signals eines Drehmomentsensors eines Servolenkungssystems eines Kraftfahrzeugs untergebracht ist.
